(19) Europäisches Patentamt
European Patent Office
Office européen des brevets

(11) **EP 0 459 700 B1**

(12) **EUROPEAN PATENT SPECIFICATION**

(45) Date of publication and mention
of the grant of the patent:
**22.11.2000 Bulletin 2000/47**

(51) Int. Cl.[7]: **H01L 21/48**, H01L 21/3205

(21) Application number: **91304658.7**

(22) Date of filing: **22.05.1991**

(54) **Wiring forming method for semiconducteur device**

Verfahren zur Verdrahtung eines Halbleiterbauelementes

Procédé de câblage pour dispositif semi-conducteur

(84) Designated Contracting States:
**AT BE CH DE DK ES FR GB GR IT LI LU NL SE**

(30) Priority: **31.05.1990 JP 14373390**
**01.06.1990 JP 14370190**

(43) Date of publication of application:
**04.12.1991 Bulletin 1991/49**

(73) Proprietor:
**CANON KABUSHIKI KAISHA**
**Tokyo (JP)**

(72) Inventors:
• **Inoue, Shunsuke,**
**Canon Kabushiki Kaisha**
**Ohta-ku, Tokyo (JP)**
• **Hasegawa, Mitsutoshi,**
**Canon Kabushiki Kaisha**
**Ohta-ku, Tokyo (JP)**
• **Watanabe, Nobuo,**
**Canon Kabushiki Kaisha**
**Ohta-ku, Tokyo (JP)**

(74) Representative:
**Beresford, Keith Denis Lewis et al**
**BERESFORD & Co.**
**High Holborn**
**2-5 Warwick Court**
**London WC1R 5DJ (GB)**

(56) References cited:
**EP-A- 0 130 398          EP-A- 0 247 714**
**US-A- 4 868 068**

• **D. BÄUERLE 'Chemical processing with lasers'**
**1986 , SPRINGER VERLAG , BERLIN DE pages**
**69-106 and 199-208**
• **APPLIED PHYSICS LETTERS vol. 52, no. 26, 27**
**June 1988, NEW YORK US pages 2230 - 2232; O.**
**GOTTSLEBEN ET AL.: 'Selective amplification of**
**self-resistively heated laser-direct-written**
**tungsten lines'**
• **JOURNAL OF APPLIED PHYSICS. vol. 66, no. 3,**
**1 August 1989, NEW YORK US pages 1403 -**
**1410; M.E. GROSS ET AL: 'Ion-beam direct-write**
**mechanisms in palladium acetate films'**
• **PATENT ABSTRACTS OF JAPAN vol. 11, no. 51**
**(E-480)17 February 1987**
• **PATENT ABSTRACTS OF JAPAN vol. 13, no. 531**
**(E-851)28 November 1989**

**Description**

The present invention relates to a method of forming wiring, particularly fine wiring patterns for semiconductor devices, such as a memory device, a photoelectric converting device, a signal processing device or the like, adapted for use in various electronic appliances.

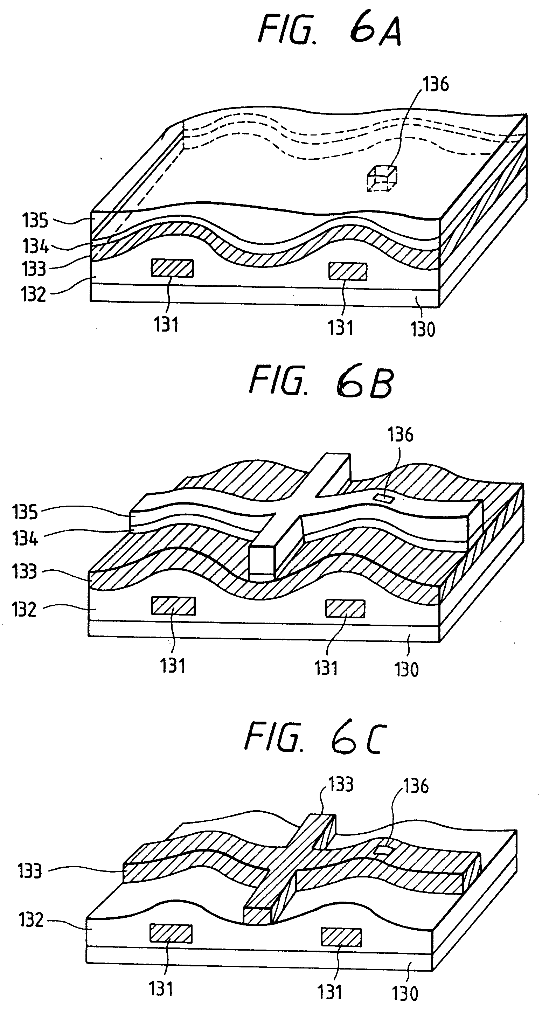

Wiring patterns in conventional integrated circuits have been formed, as shown in Figs. 6A to 6C, by depositing a conductive material on the entire surface of an insulating layer, then patterning a photoresist layer, and eliminating the unnecessary parts of said conductive material by an etching process utilising said photoresist as a mask.

In Fig. 6A, there are shown an active semiconductor layer 140, a lower Al layer 131, an insulating ($SiO_2$ or $Si_3N_4$) layer 132, an upper Al layer 133, an antireflective film 134, a photoresist layer 135, and a recess 136 in the photoresist directly above a throughhole.

The illustrated structure is obtained by the following procedure. After the formation of the wiring patterns in the lower Al layer 131, the insulating film 132 is deposited over the entire surface, and the throughole is opened. Then Al or Al-Si is deposited over the entire surface by about 1 µm, for example by magnetron sputtering with a substrate temperature of 250°C. Then, for the purpose of patterning, there are coated polyimidesilane with a thickness of 200 nm (2000 Å) as the anti-reflective film 134, and ordinary photoresist with a thickness of 1 µm. Polyimidesilane decomposes by absorbing the light energy which is not absorbed by the photoresist during the excessive exposure period after the photoresist is exposed to the bottom thereof, thereby preventing decomposition of the photoresist in the undesired area, induced by exposure to the excessive light, thus improving the precision of the patterning. The photoresist and the antireflective film are patterned by exposure of the wiring patterns with an exposure equipment for example employing an excimer laser light source (ArF line, 186 nm) and a lens with numerical aperture NA = 0.4, as shown in Fig. 6B. The exposed aluminium is removed by anisotropic etching with a RIE process, and the remaining photoresist and antireflective film are removed to obtain the desired wiring patterns as shown in Fig. 6C.

However, such conventional wiring forming method has been associated with following technical drawbacks:

(1) Since the wiring material is highly reflective in general, the light reflected or scattered on the surface of the irradiated areas of the wiring material goes astray to expose the photoresist in the areas which are not to be exposed. For this reason, photoresist patterning faithful to the mask pattern has been difficult. The antireflective film required immediately on the wiring material for this reason has complicated the photoresist process;

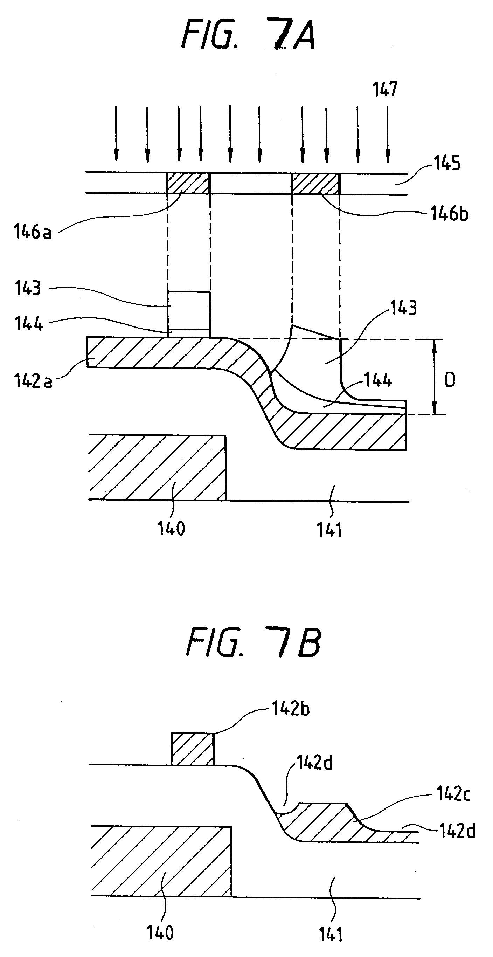

(2) If the surface irregularity under the wiring material is larger than the depth of focus of the exposure equipment, the photoresist cannot be exposed properly so that faithful photoresist patterning has been difficult. This point will be explained further with reference to Figs. 7A and 7B.

In Fig. 7A, there are shown a lower Al wiring 140, an interlayer insulation layer 141, an upper Al layer 142a deposited over the entire surface, a photoresist layer 143, an antireflective film 144, a light transmitting portion 145 of the exposure mask, opaque portions 146a, 146b of said exposure mask, and light 147 condensed by the lens. In Fig. 7B, there are shown a properly patterned upper Al layer 142b, and an improperly patterned upper Al layer 142c.

Fig. 7A illustrates the mode of exposure when the wafer surface shows significant surface irregularity, for example because of stepped portions in the underlying structure. Let us assume a case where the bottom of the photoresist to be etched has a step D, and the exposing light beam is focused to the photoresist present vertically below the pattern 146a. If $D \geqq \lambda/NA^2$ (wherein $\lambda$ is the exposing wavelength and NA is the numerical aperture of the lens), the exposing light beam - cannot be properly focused to the photoresist positioned vertically below the pattern 146b. In the above-mentioned relation, the right-hand term is a constant, called depth of focus, specific to each exposure equipment. For example, if $\lambda/NA^2$ has a representative value of 1.2 µm and if $D \geqq 1.2$ µm, the photoresist and the antireflective film present vertically below the pattern 146b are not etched according precisely to said pattern but generate an unexposed remaining portion as shown in Fig. 7A. Said remaining portion cannot be eliminated by an extended exposure time, since it is generated by the unfocused exposing light beam. If the Al wiring is formed by etching after the exposure step shown in Fig. 7A, an irregular portion 142d will be formed in the Al layer in an area 142c where the photoresist is not exposed precisely according to the mask pattern, thus eventually leading to shortcircuiting with the neighboring Al wiring.

In the latest LSI process, a surface step of 1 µm or larger is often encountered in the final wiring step, since such process is not reduced in the vertical dimension, in comparison with the horizontal dimension. Besides, the depth of focus becomes drastically smaller if the exposing wavelength $\lambda$ is made smaller and the numerical aperture is made larger for achieving a finer geometry.

As will be apparent from the foregoing description, the conventional method of fine wiring pattern formation cannot, on significant surface steps, satisfactorily cope with the progress in the fine geometry of the devices.

The object of the present invention is to provide a wiring forming method for a semiconductor device, capable of preventing the above-mentioned drawbacks and forming precise conductive patterns on an irregular surface.

In an aspect of the present invention, which is defined in the appended claims, the foregoing object can be attained by a wiring forming method for a semiconductor device having wirings on an insulating film of silicon oxide or silicon nitride, comprising steps of selectively irradiating, with a high energy beam of charged particles, areas where the wirings are to be formed on said insulating film, and depositing any of Al, Al-Si, Al-Ti, Al-Cu, Al-Si-Ti, Al-Si-Cu material thereby selectively forming wiring on said irradiated areas.

According to said aspect, the selective irradiation of the desired areas of a substrate having an insulating film with a high energy beam of charged particles, followed by deposition on the irradiated insulating film to selectively form wiring on the irradiated areas, makes it possible to form fine patterned wiring on the substrate, even in the presence of significant surface steps, without photoresist processing.

Said high energy beam of charged particles is selected from a focused electron beam, a radiation such as alpha-ray or beta-ray, an ion beam of a metal such as Al, Au, Ga, Cu or Be, and a charged particle beam of non-metallic ions such as of Si.

US-A-4868068 describes a method of depositing wiring on an insulating film by decomposing a gaseous metal compound by a focused energy beam. As described therein, an insulating film is exposed to a high energy beam to produce through holes and the through holes are filled with conducting material and thereafter metal wiring is defined by focused beam electron ion or laser induced chemical vapour deposition. Trimethyl, triethyl and tributyl aluminium are given as examples of CVD organometal compounds that may be used as aluminium source gas used in the chemical vapour deposition process. These are used with an inert gas such as Ar gas.

European Patent Application EP-A-0244081 describes a process in which tungsten single crystal material is nucleated and grown from a nucleation site of patterned Al, Si, $WSi_2$, or PdSi. There is also described a method of nucleating and growing single crystal silicon in which nucleation sites are formed by injecting ions into $SiO_2$ insulating material.

BRIEF DESCRIPTION OF THE DRAWINGS

Fig. 1 is a schematic view of an irradiating apparatus with charged particles adapted for use in the method of the present invention;

Fig. 2 is a schematic view showing selective irradiation with charged particles in an embodiment of the present invention;

Fig. 3 is a schematic view showing a wiring pattern in said embodiment;

Figs. 4 and 5 are schematic perspective views showing steps of the wiring forming method;

Figs. A to 6C are schematic perspective views showing a conventional wiring forming method; and

Figs. 7A and 7B are schematic views for explaining a conventional technology.

DETAILED DESCRIPTION OF THE PREFERRED EMBODIMENTS

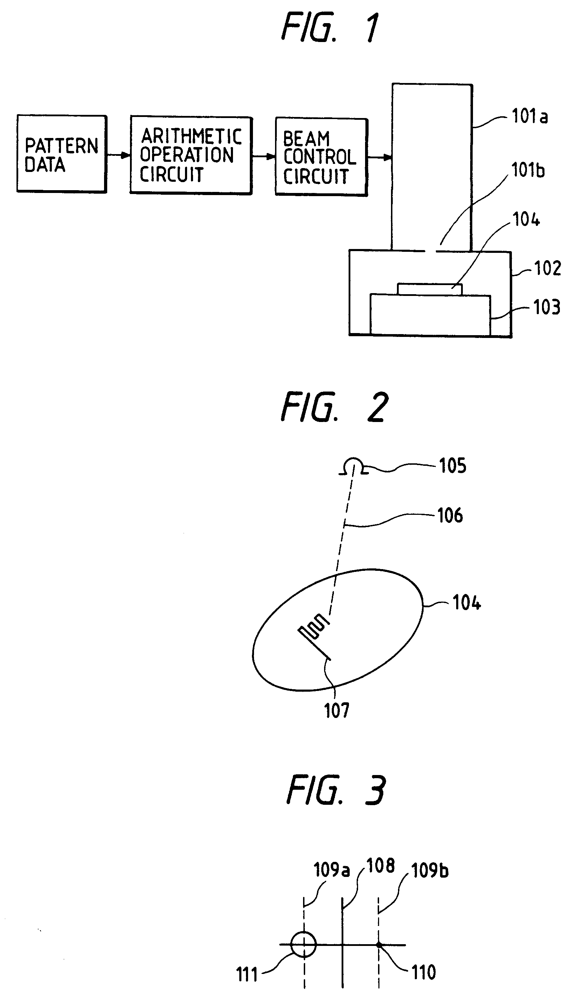

The present invention is to provide a wiring forming method without photoresist process, by irradiating the insulating film of silicon oxide or silicon nitride and the throughhole selectively with a high energy beam of charged particles by means of high energy beam irradiating means such as an electron beam irradiating apparatus or a focused ion beam irradiating apparatus as shown in Fig. 1, and then selectively depositing a conductive metallic material only in the areas irradiated with the high energy beam, by means of selective gaseous phase deposition.

The deposition method suitable for the above-mentioned wiring forming method is a CVD method utilizing alkylaluminium hydride and hydrogen (hereinafter called Al-CVD) as will be explained later.

This method allows deposition of aluminum or a metal principally composed of aluminium, of good quality, by reaction with an electron donating surface, and shows an extremely good selectivity for depositing a conductive metallic material on an electron donating surface. Therefore, this method allows, after selectively filling the contact holes having electron donating surface with a metallic material, to form an electron donating surface in the desired areas of the electron non-donating insulating film by surface modification with the high energy beam irradiation. After the formation of such electron donating in the patterns of wirings, the metal can be deposited again with satisfactory selectivity with said Al-CVD method. Consequently, in relation to the Al-CVD method, the charged particles to be implanted are preferably those related to the surface reaction system of said system, such as hydrogen ions or aluminium ions. Also there can be obtained a multi-layered wiring structure of three or more layers by repeating the above-explained procedure. Also the metal film thus obtained shows excellent characteristics as a wiring material, as will be explained later.

An electron donating material means a material in which free electrons are present or intentionally generated in the substrate and which has a surface capable of accelerating a chemical reaction by electron transfer with gas molecules deposited on said surface.

Examples of electron donating insulating material considered herein consist in silicon oxide or silicon nitride of which the surface is rendered chemically active by the irradiation with charged particles. The physical structure or chemical bond structure of the insulating surface is modified by irradiation with charged particles so as to enable a chemical reaction by electron transfer between the modified insulating surface and the deposited molecules of the raw material.

On the other hand, examples of electron non-donating material, constituting the surface not causing selective deposition of Al or Al-Si, include insulating materials with a stable surface not easily causing electron transfer, for example silicon oxide formed by thermal oxidation or CVD, glass, oxide film or thermally nitrogenized film for example of BSG, PSG or BPSG, and silicon nitride film formed by plasma CVD, reduced pressure CVD or ECR-CVD.

As described hereinbelow, a deposition film is formed on an electron donating substrate by a surface reaction, utilising alkylaluminium hydride gas and hydrogen gas. A particularly excellent aluminium film can be deposited by employing monomethylaluminium hydride (MMAH) or dimethylaluminium hydride (DMAH) as the raw material gas with hydrogen gas as the reaction gas, and heating the substrate surface under the presence of the mixture of these gases. In the selective deposition of aluminium, the surface temperature of the substrate is preferably maintained, by direct or indirect heating, between the decomposition temperature of alkylaluminium hydride and 450°C, more preferably between 260°C and 440°C.

The substrate can be heated to the above-mentioned temperature range either by direct or indirect heating, but an aluminium film of satisfactory quality can be deposited with a high deposition speed, if the substrate is maintained within said temperature range by direct heating. For example, a satisfactory film can be obtained with a deposition speed of 300-500 nm (3000-5000 Å), higher than that obtainable with resistance heating, when the surface temperature of the substrate is maintained within a more preferable temperature range of 260°C - 440°C. Such direct heating (substrate being heated by direct transmission of the energy from heating means) is for example achieved by lamp heating with a halogen lamp or a xenon lamp. Also indirect heating can be achieved for example by resistance heating, which can be conducted with a heat generating member provided in a support member for supporting the substrate on which the deposition film is to be formed, positioned in a space for said film deposition.

Such Al-CVD method, if applied to a substrate bearing an electron donating surface area and an electron non-donating surface area allows to form an aluminium single crystal only on the electron donating surface area with satisfactory selectivity. Such aluminium is provided with excellent characteristics in all the properties required for the electrode/wiring material, including decrease in the probability of formation of hillocks and alloy spikes. This is presumably due to a fact that alloy spike formation resulting from an eutectic reaction of aluminium with silicon in the substrate is scarce, because aluminium of satisfactory quality can be selectively formed on the electron donating surface and is furthermore excellent in crystallinity.

The aforementioned Al-CVD method can also achieve selective deposition of the following metal films principally composed of aluminium, with excellent properties:

Al-Si, Al-Ti, Al-Cu, Al-Si-Ti or Al-Si-Cu, by employing a mixed gas atmosphere containing, in addition to alkylaluminium hydride gas and hydrogen, a suitable combination of:
silicon-containing gas such as $SiH_4$, $Si_2H_6$, $Si_3H_8$, $Si(CH_3)_4$, $SiCl_4$, $SiH_2Cl_2$ or $SiHCl_3$;
titanium-containing gas such as $TiCl_4$, $TiBr_4$ or $Ti(CH_3)_4$; and
copper-containing gas such as copper bisacetyl-acetonate $Cu(C_5H_7O_2)_2$, copper bisdipivaloylmethanite $Cu(C_{11}H_{19}O_2)_2$ or copper bishexafluoroacetylacetonate $Cu(C_5HF_6O_2)_2$.

Example of prepared starting substrate:

Firstly, there will be explained a process of filling contact holes using said Al-CVD method. The present invention is to provide improvements in the subsequent wiring formation on said insulating film and filled contact holes by using selective Al-CVD instead of sputtering and patterning, thus providing an excellent wiring forming method.

At first there were prepared, as the substrate, N-type monocrystalline silicon wafers on which a $SiO_2$ layer of a thickness of 800 nm (8000 Å) was formed by thermal oxidation, in which square apertures of different sizes from 0.25 x 0.25 μm to 100 x 100 μm were formed by patterning to expose the underlying monocrystalline silicon (sample 1-1).

These substrates were subjected to Al film formation by the Al-CVD method, employing DMAH as the raw material gas and hydrogen as the reaction gas with a total pressure of 200 Pa (1.5 Torr) and a DMAH partial pressure of $6.7 \times 10^{-1}$ Pa ($5.0 \times 10^{-3}$ Torr), and the substrate surface temperature within a range of 200° to 490°C, with regulation of the electric power supplied to the halogen lamps for direct heating.

The obtained results are summarised in Table 1.

Table 1

| Substrate surface temperature (°C) | 200 | 230 | 250 | 260 | 270 | 280 | 300 | 350 | 400 | 440 | 450 | 460 | 470 | 480 | 490 |
|---|---|---|---|---|---|---|---|---|---|---|---|---|---|---|---|
| Deposition speed (nm/min) | 100~150 | | | 300~500 → | | | | | | | | | | | |
| Throughput (substrate/hr) | 7~10 | | | | 15~30 → | | | | | | | | | | |
| Si linear defect | not observed | | | | | | | | | | | | | | |
| Carbon content | not detected | | | | | | | | | | | | | | |
| Resistivity (μΩcm) | 2.7~3.3 | | | 2.8~3.4 → | | | | | | | | | | | |
| Reflectance (%) | 85~95 | | | 90~95 → | | | | | | | | | | | |
| Hillock density (≥1 μm; /cm²) | 1~10² | | | 0~10 | | | | | | | 10~10⁴ → | | | | |
| Spike formation (%) (probability of destruction of 0.15 μm junction) | 0 | | | | | | | | | | 0~30 → | | | | |

As will be apparent from Table 1, a substrate surface temperature equal to or higher than 260°C, obtained by direct heating, provided selective aluminium deposition in the aperture with a deposition speed as high as 300 - 500 nm/min.

The aluminium film obtained in the aperture within a substrate surface temperature range of 260° to 440°C was free from carbon, and showed a resistivity of 2.8 - 3.4 $\mu\Omega$cm, a reflectance of 90 - 95 %, a hillock density ($\geqq 1 \mu$m) of 0 - 10 cm$^{-2}$, and almost no spike formation (probability of destruction of 0.15 $\mu$m junction).

On the other hand, within a substrate surface temperature range of 200° - 250°C, the quality of the obtained film was somewhat lower than that obtained in the temperature range of 260° - 440°C but was considerably better than that obtainable in the conventional technology. However, the deposition speed was not sufficiently high, being in a range of 100 - 150 nm/min., and the throughput was also relatively low, being 7 - 10 substrate/hr.

Also in a substrate surface temperature range equal to or higher than 450°C, the quality of the aluminium film in the aperture was lowered, with a reflectance not exceeding 60 %, a hillock density ($\geqq 1 \mu$m) of 10 - 10$^4$ cm$^{-2}$ and an alloy spike formation of 0 - 30 %.

In the following there will be explained how the above-explained method can be advantageously applied to apertures such as contact holes or throughholes.

More specifically, said method can also be advantageously applied to a contact hole or throughhole structure of the following materials.

The aluminium film formation was conducted on following substrates (samples) under same conditions as on the aforementioned samples 1-1.

On monocrystalline silicon constituting a first substrate surface material, a silicon oxide film constituting a second substrate surface material was formed by a CVD method, and was patterned by a photolithographic process to partially expose the monocrystalline silicon surface.

The thickness of the thermal SiO$_2$ film was 800 nm (8000 Å), and the size of the apertures in which the monocrystalline silicon was exposed was 0.25 x 0.25 $\mu$m - 100 x 100 $\mu$m. This sample is called sample 1-2 (this sample being hereinafter represented as "CVD SiO$_2$ (or simply represented as SiO$_2$)/monocrystalline silicon".

A sample 1-3 consisted of a boron-doped oxide film formed by normal pressure CVD (hereinafter represented as BSG)/monocrystalline silicon.

A sample 1-4 consisted of a phosphor-doped oxide film formed by normal pressure CVD (hereinafter represented as PSG)/monocrystalline silicon.

A sample 1-5 consisted of a phosphor- and boron-doped oxide film formed by normal pressure CVD (hereinafter represented as BSPG)/monocrystalline silicon.

A sample 1-6 consisted of a nitride film formed by plasma CVD (hereinafter represented as P-SiN)/monocrystalline silicon.

A sample 1-7 consisted of a thermal nitride film (hereinafter represented as T-SiN)/monocrystalline silicon.

A sample 1-8 consisted of a nitride film formed by low pressure CVD (hereinafter represented as LP-SiN)/monocrystalline silicon.

A sample 1-9 consisted of a nitride film formed by ECR apparatus (hereinafter represented as ECR-SiN)/monocrystalline silicon.

Also samples 1-11 to 1-179 were prepared by taking all the combinations of following first substrate surface materials (18 kinds) and following second substrate surface materials (9 kinds): it is to be noted, however, that the sample numbers 1-10, 20, 30, 40, 50, 60, 70, 80, 90, 100, 110, 120, 130, 140, 150, 160 and 170 are not present. The first substrate surface materials employed were monocrystalline silicon (mono-Si); polycrystalline silicon (poly-Si); amorphous silicon (a-Si); tungsten (W); molybdenum (Mo); tantalum (Ta); tungsten silicide (WSi); titanium silicide (TiSi); aluminium (Al); aluminium-silicon (Al-Si); titanium-aluminium (Al-Ti); titanium nitride (Ti-NB); copper (Cu); aluminium-silicon-copper (Al-Si-Cu); aluminium-palladium (Al-Pd); titanium (Ti); molybdenum suicide (Mo-Si); and tantalum silicide (Ta-Si). The second substrate surface materials employed were T-Si0$_2$, Si0$_2$, BSG, PSG, BPSG, P-SiN, T-SiN, LP-SiN, and ECR-SiN. In all these samples, there could be obtained satisfactory aluminium films comparable in quality to that in the afore-mentioned sample 1-1.

Preferred Embodiment

Description of circuit

In the present embodiment, there will be explained, in a two-layered aluminium wiring process for a semiconductor integrated circuit, a method of forming the upper aluminium wiring layer. Fig. 3 shows only a limited part of grid-shaped aluminium wiring pattern employed in the present embodiment, wherein 108 is an upper aluminium wiring, while 109a and 109b are lower aluminium wirings. At a crossing point 110 of the wirings 109b and 108, a black dot indicates that both wirings are mutually connected by a through-hole. At the other crossing point 111 of the wirings 109a and 108, no through-hole is provided so that both wirings are not mutually connected. Such method of making or not making the connection by the presence or absence of a through-hole may be applied in the preparation of a custom LSI such as a gate array. More specifically, the process steps are executed in advance to a level before the preparation of the through-holes, and the positions of the through-holes are determined according to the circuit requested by the customer, thereby forming the final circuit.

Description of apparatus for forming wirings

Fig. 1 is a schematic view of a focused ion beam irradiating system adapted for use in the present embodiment. The pattern data for the upper aluminium wiring layer are converted by a calculating circuit into data for controlling an ion beam.

A focused ion beam source 101a is provided with an ion beam source, an ion optical system, and an electrostatic lens system. The ion beam generated in said source 101a and direction controlled by said ion optical system and electrostatic lens system irradiates a semiconductor substrate 104 through an aperture 101b.

Fig. 2 shows the mode of pattern writing with ion beam irradiation. There are shown the ion source, ion optical system and electrostatic lens system 105, an ion beam 106, the semiconductor substrate 104, and a pattern 107 irradiated by the ion beam.

Wiring forming method

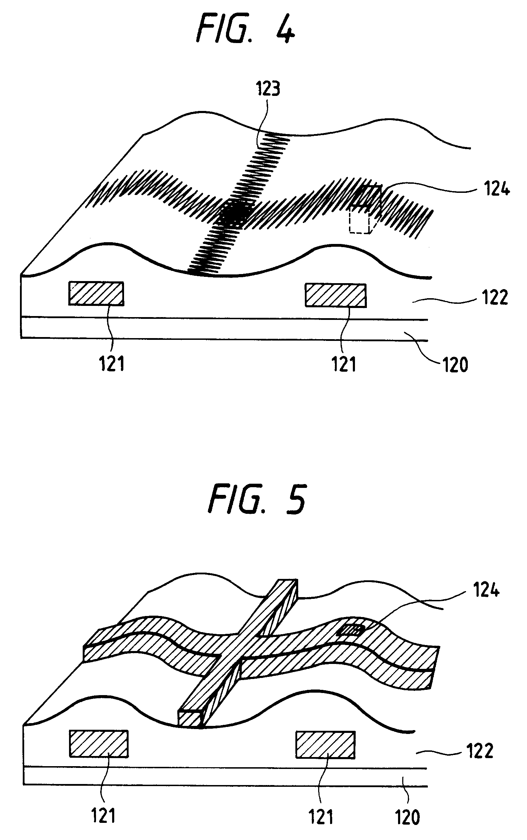

In the following there will be explained the method of forming aluminium wirings in the present embodiment, with reference to Figs. 1 to 5. The pattern data for the aluminium wirings of the upper layer are prepared as explained above. In a writing chamber 102, there is prepared a semiconductor substrate 104, which is provided already with aluminium wirings of the lower layer, an insulating film covering said aluminium wirings, and through-holes for connecting the aluminium wirings of the upper layer with those of the lower layer and which is to be irradiated with the ion beam. After the wiring pattern is written with the ion beam as shown in Fig. 2, the semiconductor substrate is taken out from the chamber 102. Fig. 4 shows the substrate in this state, wherein shown are an active area 120 of the silicon substrate, aluminium wirings 121 of the lower layer, an insulating film 122, an area 123 irradiated with the ion beam, and a through-hole aperture 124.

Then said substrate is placed in a chamber for gaseous aluminium growth, and subjected to the aluminium deposition on the irradiated area 123 and in the through-hole 124, employing DMAH (dimethyl aluminium hydride: $Ah(CH_3)_2$) gas and hydrogen as the reaction gas, at a substrate surface temperature of about 290°C. The deposited thickness of aluminium is about 800 nm (8000 Å). Fig. 5 shows the state immediately after said deposition. A subsequent heat treatment at 400°C for about 3 minutes in a nitrogen atmosphere improves the ohmic contact between the upper and lower aluminium layers, thereby obtaining a sufficiently low contact resistance.

Example

Plural samples of the form shown in Fig. 5 were prepared by the above-explained procedure, employing an aluminium ion beam.

In these examples, the width of the upper aluminium layer (line width) was varied within a range of 0.25 - 2 µm; the distance between the upper aluminium layers (space width) was varied within a range of 0.25 - 2 µm, and the maximum step was varied within a range of 0.6 - 2.4 µm by varying the thickness of the lower aluminium layer.

Reference examples

Samples were prepared by the conventional method ($\lambda$ = 186 nm, NA = 0.40), with the line width of 0.25 - 2 µm, space width of 0.25 - 2 µm and the maximum step of 0.5 - 2.0 µm obtained by varying the lower aluminium thickness.

Results of comparison

Table 2

| Maximum step (μm) | 0.6 | 1.2 | 1.8 | 2.4 |
|---|---|---|---|---|
| Upper Al Line width (L)/Space width (S) (μm) | | | | |
| 2 /2 | ++/+ | ++/± | +/- | +/- |
| 1.5/1.5 | ++/+ | ++/± | +/- | +/- |
| 1.0/1.0 | ++/+ | +/- | -/- | +/- |
| 0.8/0.8 | ++/± | +/- | +/- | +/- |
| 0.5/0.5 | ++/± | +/- | +/- | ±/- |
| 0.25/0.25 | +/- | +/- | +/- | ±/- |
| Note: Results of evaluation indicate Example/Ref. Ex. | | | | |

Table 2 shows the evaluation of form of the upper aluminium wirings in the samples prepared according to the method of the present invention and according to the conventional method, taking the maximum step on the wafer and the line and space width of aluminium as parameters. In Table 2, "++" indicates completely satisfactory patterning; "+" indicates almost satisfactory patterning; "±" indicates a certain deformation in the pattern; and "-" indicates a defect such as shortcircuiting between the wirings. The examples of the present invention showed wirings without defects such as shortcircuiting, in any condition in Table 2, as indicated in the left-hand half in each column. On the other hand, the conventional method was unable to form line/space pattern without defects if said pattern was of a width of 0.25 μm or on a step in excess of 1.0 μm.

The present embodiment enables highly reproducible film formation over a prolonged period, since the electron donating surface, obtained by surface modification with ions, shows little change in time.

Also the width of wirings can be well controlled, since the use of ion beam suppresses the charging of the substrate at the writing of writing patterns.

Furthermore, the Al-CVD method employing hydrogen ions or aluminium ions as the charged particles allows to obtain a film of further improved characteristics for the wirings, because of the preferred reaction system.

Effect of the present embodiment

(1) The entire process is simplified because the steps of forming the antireflective layer and the resist layer can be dispensed with, so that the product yield which has been limited by defective patterning can be significantly improved:

(2) A desired wiring pattern can be formed even over a deep surface step:

(3) This method is effective for chip miniaturization, because the pattern size can be made as small as the beam diameter of the beam source-:

(4) This selective gaseous growth method provides highly reliable wirings with good step coverage, even when the pattern is miniaturized.

Also in the foregoing embodiment, an electron beam exposure apparatus instead may be employed as the high energy beam irradiating means.

In this case, the ion beam source and optical system 101a shown in Fig. 1 are replaced by a focused electron beam source, including an electron beam source, a condensing lens and a deflecting lens. The electron beam generated in said source and direction controlled by said lenses irradiates the semiconductor substrate 104 through the aperture 101b.

The pattern is written by the electron beam irradiation, in a similar manner as shown in Fig. 2. The ion source, optical system and electrostatic lens 105 shown in Fig. 2 are replaced by the electron beam source and the deflecting lens, and 106 becomes the electron beam. 104 is the semiconductor substrate, and 107 is the pattern irradiated by the electron beam.

The energy beam employable in the present invention may be selected from radiations such as alpha-ray or beta-ray, and beams of metallic ions such as Al, Au, Ga, Cu and Be, and of non-metallic ions such as Si.

## Claims

1. A method of forming wiring comprising the following steps:

   providing a semiconductor device substrate having an insulating film of silicon oxide or silicon nitride thereon;
   defining a predetermined wiring pattern by selectively irradiating an area of said insulating film with a high energy beam of charged particles thereby modifying the physical or chemical bond structure thereof and thus making said area electron donative; and thereafter
   forming wiring having said predetermined wiring pattern by depositing aluminium, or an aluminium metallic compound selected from Al-Si, Al-Ti, Al-Cu, Al-Si-Ti or Al-Si-Cu, on said area, by selective chemical vapour deposition using an alkyl aluminium hydride and hydrogen, or using an alkyl aluminium hydride, hydrogen and any of a silicon-containing gas, a titanium-containing gas, or a copper-containing gas, or a mixture of a silicon-containing gas and either of a titanium-containing gas or a copper containing gas, respectively as respective sources of the silicon, titanium, and copper.

2. A method according to claim 1 wherein said high energy beam of charged particles is a focused electron beam.

3. A method according to claim 1 wherein said high energy beam of charged particles is a beam of alpha or beta particles.

4. A method of producing a semiconductor device having wiring, which method includes forming said wiring by a method of forming wiring as claimed in the preceding claims.

## Patentansprüche

1. Verfahren zur Leiterbahnausbildung mit den Schritten

   Bereitstellen eines Halbleitervorrichtungssubstrates mit einer isolierenden Schicht aus Siliziumoxid oder Siliziumnitrid darauf;
   Definieren einer vorbestimmten Leiterbahnstruktur durch selektives Bestrahlen eines Bereiches der isolierenden Schicht mit einem Hochenergiestrahl geladener Teilchen, wodurch dessen physikalische oder chemische Bindungsstruktur modifiziert wird und somit der Bereich Elektronen abgebend wird; und danach
   Ausbilden einer Leiterbahn mit der vorbestimmten Leiterbahnstruktur, indem Aluminium oder eine Aluminiummetallverbindung aus der Gruppe Al-Si, Al-Ti, Al-Cu, Al-Si-Ti und Al-Si-Cu auf dem Bereich durch selektive chemische Gasphasenabscheidung unter Verwendung eines Alkylaluminiumhydrids und Wasserstoff oder unter Verwendung eines Alkylaluminiumhydrids, Wasserstoff und einem Silizium enthaltenden Gas, einem Titan enthaltenden Gas oder einem Kupfer enthaltenden Gas oder einer Mischung aus einem Silizium enthaltenden Gas und entweder einem Titan enthaltenden Gas oder einem Kupfer enthaltenden Gas als jeweilige Quellen für Silizium, Titan und Kupfer abgeschieden wird.

2. Verfahren nach Anspruch 1, wobei der Hochenergiestrahl geladener Teilchen ein fokussierter Elektronenstrahl ist.

3. Verfahren nach Anspruch 1, wobei der Hochenergiestrahl geladener Teilchen ein Strahl aus Alpha- oder Betateilchen ist.

4. Verfahren zur Herstellung einer Halbleitervorrichtung mit einer Leiterbahn, wobei das Verfahren die Ausbildung der Leiterbahn durch ein Verfahren zur Leiterbahnausbildung gemäß einem der vorstehenden Ansprüche umfasst.

## Revendications

1. Procédé de formation d'un câblage comprenant les étapes dans lesquelles :

   on utilise un substrat de dispositifs semiconducteurs portant un film isolant d'oxyde de silicium ou de nitrure de silicium ;

on définit un motif de câblage prédéterminé en irradiant sélectivement une zone dudit film isolant avec un faisceau à haute énergie de particules chargées afin de modifier sa structure de liaison physique ou chimique et de rendre ainsi ladite zone donneuse d'électrons ; et ensuite

on forme le câblage ayant ledit motif de câblage prédéterminé en déposant de l'aluminium, ou un composé métallique d'aluminium choisi parmi Al-Si, Al-Ti, Al-Cu, Al-Si-Ti ou Al-Si-Cu sur ladite zone, par dépôt chimique sélectif en phase vapeur utilisant un hydrure d'alkylaluminium et de l'hydrogène, ou utilisant un hydrure d'alkylaluminium, de l'hydrogène et l'un quelconque d'un gaz contenant du silicium, d'un gaz contenant du titane ou d'un gaz contenant du cuivre, ou d'un mélange d'un gaz contenant du silicium et de l'un d'un gaz contenant du titane ou d'un gaz contenant du cuivre, respectivement, en tant que sources respectives du silicium, du titane et du cuivre.

2. Procédé selon la revendication 1, dans lequel ledit faisceau à haute énergie de particules chargées est un faisceau focalisé d'électrons.

3. Procédé selon la revendication 1 dans lequel ledit faisceau à haute énergie de particules chargées est un faisceau de particules alpha ou bêta.

4. Procédé de production d'un dispositif semiconducteur ayant un câblage, lequel procédé comprend la formation dudit câblage par un procédé de formation de câblage selon les revendications précédentes.

## FIG. 1

PATTERN DATA → ARITHMETIC OPERATION CIRCUIT → BEAM CONTROL CIRCUIT →

101a
101b
104
102
103

## FIG. 2

105
106
104
107

## FIG. 3

109a    108    109b
111    110

## FIG. 4

## FIG. 5

## FIG. 6A

136

135
134
133
132

131          131          130

## FIG. 6B

136

135
134
133
132

131          131          130

## FIG. 6C

133          136

133

132

131          131          130

# FIG. 7A

147

145

146a

146b

143

144

142a

143

144

D

140

141

# FIG. 7B

142b

142d

142c

142d

140

141